# EUROPEAN PATENT APPLICATION

(11) **EP 4 770 395 A1**
(43) Date of publication of application: **01.07.2026**
(21) Application number: 25218739.8
(22) Date of filing: 26.11.2025
(51) Int. Cl.: H10K 59/80, H10K 59/131, H10K 59/40

(54) **LIGHT EMITTING DISPLAY APPARATUS**

(30) Priority: 30.12.2024 KR 20240201475
(71) Applicant: LG Display Co., Ltd., Seoul, 07336 (KR)
(72) Inventor: LIM, YuSok, 10845 Paju-si (KR); RYU, Youngwan, 10845 Paju-si (KR); CHAE, Jieun, 10845 Paju-si (KR); SEO, YeongRae, 10845 Paju-si (KR)
(74) Representative: Ter Meer Steinmeister & Partner

(57) **Abstract**

A light emitting display apparatus according to one or more embodiments of the present disclosure may include a substrate on which a display area and a pad area are disposed, an encapsulation portion extending from the display area toward the pad area on the substrate, at least one inorganic insulating layer disposed on the encapsulation portion, a pad electrode disposed in the pad area on the substrate and electrically connected to respective signal link lines, and a pad cover portion configured to cover at least a portion of the pad electrode in the pad area, the at least one inorganic insulating layer may include an extension pattern portion configured to overlap an end of the pad cover portion.

## Description

This application claims priority to Korean Patent Application No. 10-2024-0201475 filed in Republic of Korea on December 30, 2024.

### BACKGROUND

### Technical Field

The present disclosure relates to a light emitting display apparatus.

### Description of the Related Art

With the development of information society, the demand for a display apparatus for displaying images has been increasing in various forms. Accordingly, display apparatuses such as a liquid crystal display (LCD) apparatus, an organic light emitting display (OLED) apparatus, a micro light emitting diode display (Micro-LED) apparatus, a quantum dot display (QD) apparatus, and the like are used.

The light emitting display apparatus may include an encapsulation layer to block the infiltration of moisture or oxygen from the outside. The encapsulation layer may include at least one inorganic layer and at least one organic layer to prevent the infiltration of moisture and oxygen.

### SUMMARY

The light emitting display apparatus may have a Touch on Encapsulation (ToE) structure in which a plurality of touch sensors and a plurality of touch sensor lines are directly formed on the encapsulation layer to implement a touch function. However, during the process of forming the ToE structure, the inorganic film of the encapsulation layer may be damaged or cracks may occur. Through these cracks, moisture may penetrate in a high-temperature and high-humidity environment, causing corrosion, in particular to a signal voltage line disposed in the pad area, which may lead to electrolytic corrosion failure.

It is an object to provide a light emitting display apparatus capable of preventing moisture from penetrating through the pad area of the display panel.

It is an object to provide a light emitting display apparatus capable of preventing damage or crack defects in the inorganic film in the pad area. It is an object to provide a light emitting display apparatus capable of preventing electrolytic corrosion failure of a signal voltage line disposed in the pad area.

It is an object to provide a light emitting display apparatus with improved reliability in a high-temperature and high-humidity environment.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

The object is solved by the features of the independent claims. Preferred embodiments are given in the dependent claims.

A light emitting display apparatus of the disclosure may include a substrate including a display area and a pad area, an encapsulation portion extending from the display area toward the pad area on the substrate, at least one first inorganic insulating layer disposed on the encapsulation portion, a pad electrode disposed in the pad area on the substrate and electrically connected to respective signal link lines, and a pad cover portion configured to cover at least a portion of the pad electrode in the pad area, the at least one first inorganic insulating layer may include an extension pattern portion configured to overlap an end of the pad cover portion.

In one or more embodiments, the extension pattern portion may extend from one side of the at least one inorganic insulating layer to overlap the respective signal link lines.

In one or more embodiments, the extension pattern portion may include a plurality of finger patterns overlapping the respective signal link lines.

In one or more embodiments, the extension pattern portion may have a slit shape between the adjacent signal link lines.

In one or more embodiments, the pad electrode may include a plurality of pad electrodes arranged in a first direction on the substrate.

**In** one or more embodiments, the pad cover portion may be configured to extend in the first direction to cover the plurality of pad electrodes.

In one or more embodiments, the pad cover portion may comprise an organic material.

**In** one or more embodiments, the light emitting display apparatus may comprise a pixel circuit layer having a pixel circuit and disposed in the display area on the substrate; a planarization layer configured to cover the pixel circuit layer in the display area; and a light emitting device disposed on the planarization layer in the display area and connected to the pixel circuit.

**In** one or more embodiments, the encapsulation portion may be disposed on the planarization layer to cover the light emitting device.

In one or more embodiments, the pad cover portion may comprise the same material as the planarization layer.

In one or more embodiments, the pad cover portion may have a height that is equal to or lower than that of the planarization layer.

In one or more embodiments, the signal link line may include a display driving link line.

In one or more embodiments, at least one portion of the display driving link line may be disposed in the same layer as a gate electrode of a thin film transistor included in the pixel circuit and as a gate line.

In one or more embodiments, the display driving link line may be connected to the pad electrode, extends to the display area, and is electrically connected to a data line disposed in the display area.

**In** one or more embodiments, the pixel circuit layer may include an interlayer insulating layer disposed on the gate electrode.

**In** one or more embodiments, the interlayer insulating layer may be disposed to extend to the pad area on the substrate.

In one or more embodiments, the pad electrode may include a display pad electrode electrically connected to the display driving link line through a contact hole passing through the interlayer insulating layer.

**In** one or more embodiments, the pad cover portion may cover at least a portion of the display pad electrode.

**In** one or more embodiments, the pad cover portion may include an opening pattern exposing another portion of the display pad electrode.

**In** one or more embodiments, the light emitting display apparatus may comprise a display connection pad electrode disposed on the pad cover portion.

**In** one or more embodiments, one end of the display connection pad electrode may be spaced apart from the extension pattern portion on the pad cover portion.

**In** one or more embodiments, another end of the display connection pad electrode may extend toward the pad area, and may be electrically connected to the display pad electrode exposed through the opening pattern of the pad cover portion.

**In** one or more embodiments, the at least one inorganic insulating layer may include: a touch buffer layer disposed on the encapsulation portion; and a touch insulating layer disposed on the touch buffer layer.

**In** one or more embodiments, the touch buffer layer and the touch insulating layer may extend to overlap the display driving link line and the end of the pad cover portion.

**In** one or more embodiments, the display driving link line may include first and second display driving link lines overlapping to form a single signal line.

**In** one or more embodiments, the first display driving link line may be formed of the same material in a same layer as the gate electrode.

In one or more embodiments, the second display driving link line may be formed of the same material in a same layer as an intermediate metal layer disposed in the interlayer insulating layer.

**In** one or more embodiments, the light emitting display apparatus may comprise a touch electrode array disposed on the encapsulation portion in the display area.

In one or more embodiments, the signal link line may include a touch driving link line electrically connected to the touch electrode array.

In one or more embodiments, the at least one inorganic insulating layer may include: a touch buffer layer disposed on the encapsulation portion; and a touch insulating layer disposed on the touch buffer layer.

In one or more embodiments, the touch electrode array and the touch driving link line may be disposed between the touch buffer layer and the touch insulating layer.

In one or more embodiments, the touch driving link line may be disposed to overlap the end of the pad cover portion between the touch buffer layer and the touch insulating layer.

In one or more embodiments, the extension pattern portion may include the touch insulating layer disposed above the touch driving link line and the touch buffer layer disposed below the touch driving link line.

In one or more embodiments, the pad electrode may include a touch pad electrode electrically connected to the touch driving link line through an opening pattern passing through the pad cover portion.

In one or more embodiments, the light emitting display apparatus may comprise a touch connection pad electrode disposed on the pad cover portion.

In one or more embodiments, one end of the touch connection pad electrode may extend toward the display area and may be electrically connected to the touch driving link line through a contact hole passing through the touch insulating layer.

In one or more embodiments, another end of the touch connection pad electrode may extend toward the pad area and may be electrically connected to the touch pad electrode exposed through the opening pattern of the pad cover portion.

In one or more embodiments, the encapsulation portion may cover the entire display area and extends to a non-display area except for the pad area.

In one or more embodiments of the disclosure, a light emitting display apparatus capable of preventing moisture from penetrating through the pad area of the display panel, may be provided.

In one or more embodiments of the disclosure, a light emitting display apparatus capable of preventing damage or crack defects in the inorganic film in the pad area, may be provided.

In one or more embodiments of the disclosure, a light emitting display apparatus capable of preventing electrolytic corrosion failure of a signal voltage line disposed in the pad area, may be provided.

In one or more embodiments of the disclosure, a light emitting display apparatus with improved reliability in a high-temperature and high-humidity environment, may be provided.

The light emitting display apparatus of the disclosure may prevent damage or cracking defects of the inorganic film in the pad area of the display panel, and may prevent moisture from penetrating through the pad area. Accordingly, electrolytic corrosion failure of the signal voltage line disposed in the pad area may be prevented, and reliability in high-temperature and high-humidity environments may be improved. As a result, the manufacturing process of the light emitting display apparatus may be optimized, power consumption may be reduced for low-power operation, and the lifespan of the apparatus may be extended, thereby enabling the implementation of Environment/Social/Governance (ESG) by reducing energy consumption during production.

The effects of the disclosure are not limited to the aforesaid, but other effects not described herein will be clearly understood by the skilled person from the following descriptions.

The details of the disclosure described in technical problem, technical solution, and advantageous effects do not specify essential features of claims, and thus, the scope of claims is not limited by the details described in detailed description of the invention.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain the principles and examples of the disclosure.
FIG. 1 illustrates a schematic configuration of a light emitting display apparatus of an embodiment of the disclosure.
FIG. 2 illustrates a light emitting display apparatus of an embodiment of the disclosure.
FIG. 3 illustrates a structure in which a touch panel is embedded in a display panel of an embodiment of the disclosure.
FIG. 4 illustrates a region A shown in FIG. 2 of an embodiment of the disclosure.
FIG. 5 is a cross-sectional view taken along line I-I' of FIG. 4 of an embodiment of the disclosure.
FIG. 6 illustrates a region B shown in FIG. 4 of an embodiment of the disclosure.
FIG. 7 is a cross-sectional view taken along line II-II' of FIG. 6 of an embodiment of the disclosure.
FIG. 8 is a cross-sectional view taken along line III-III' of FIG. 6 of an embodiment of the disclosure.
FIG. 9 illustrates a region C shown in FIG. 4 of another embodiment of the disclosure.
FIG. 10 is a cross-sectional view taken along line IV-IV' of FIG. 9 of another embodiment of the disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION OF THE DISCLOSURE

Advantages and features of the disclosure, and implementation methods thereof, are clarified through the embodiments described with reference to the accompanying drawings. The disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the disclosure.

Shapes (e.g., sizes, lengths, widths, heights, thicknesses, locations, radii, diameters, and areas), dimensions, ratios, angles, numbers, and the like disclosed herein, including those illustrated in the drawings are merely examples, and thus, the disclosure is not limited to the illustrated details. Any implementation described herein as an "example" is not necessarily to be construed as preferred or advantageous over other implementations. It is, however, noted that the relative dimensions of the components illustrated in the drawings are part of the disclosure.

When the term "comprise," "have," "include," "contain," "constitute," "made of," "formed of," or the like is used with respect to one or more elements, one or more other elements may be added unless a term such as "only" or the like is used. The terms used in the disclosure are merely used in order to describe example embodiments, and are not intended to limit the scope of the present disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

**In** describing elements of the present disclosure, the terms "first," "second," "A," "B," "(a)," "(b)," or the like may be used. These terms are intended to identify the corresponding element(s) from the other element(s), and these terms are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "contacts," "overlaps," or the like with another element, the element may not only directly contact, overlap, or the like with another element, but also indirectly contact, overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments of the disclosure may be partially or entirety coupled to or combined with each other, may be technically associated with each other, and may be variously inter-operated, linked or driven together. The embodiments of the disclosure may be implemented or carried out independently of each other, or may be implemented or carried out together in a co-dependent or related relationship. In one or more aspects, the components of each apparatus according to various embodiments of the disclosure are operatively coupled and configured.

In the following description, various example embodiments of the disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same or similar reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

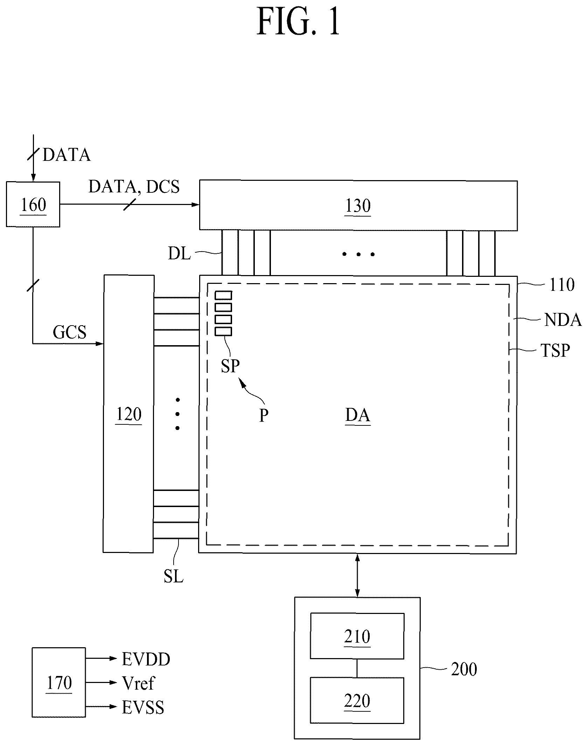

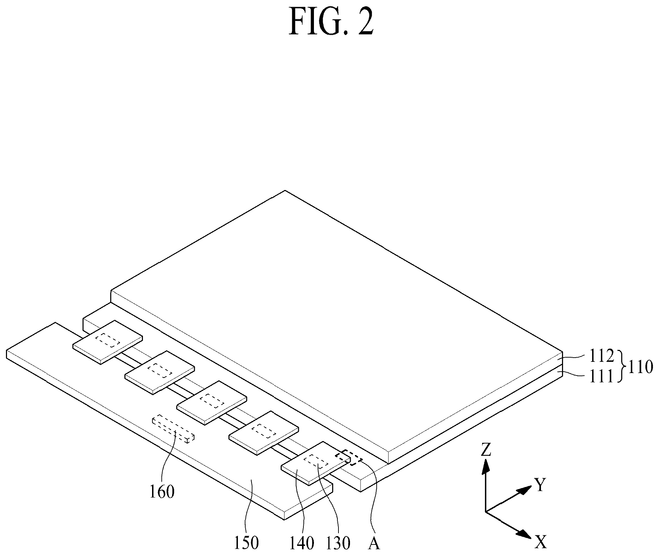

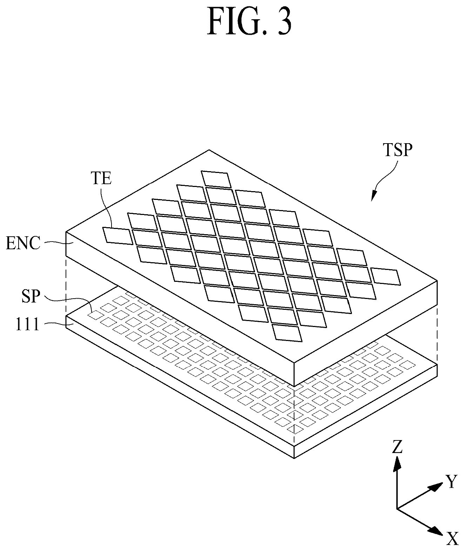

FIG. 1 illustrates a schematic configuration of a light emitting display apparatus of an embodiment of the disclosure. FIG. 2 illustrates a light emitting display apparatus of an embodiment of the disclosure. FIG. 3 illustrates a structure in which a touch panel is embedded in a display panel of an embodiment of the disclosure.

Hereinafter, X-axis represents a direction parallel with a scan line (or a gate line), Y-axis represents a direction parallel with a data line, and Z-axis represents a height direction of the light emitting display apparatus.

A light emitting display apparatus of an embodiment of the disclosure may be implemented as an organic light emitting display apparatus, but may also be implemented as a liquid crystal display apparatus, a quantum dot light emitting diode display apparatus, or an electrophoretic display apparatus. Also, the light emitting display apparatus of an embodiment of the disclosure may be implemented as a touch display apparatus in which a touch function is embedded in the display panel.

Referring to FIGS. 1 to 3, the light emitting display apparatus of an embodiment of the disclosure may provide image display function and touch sensing function.

In order to provide an image display function, the light emitting display apparatus of an embodiment of the disclosure may include a display panel 110, a scan driver 120 (or a gate driver) embedded in the display panel 110, a data driver 130 connected to the display panel 110, a timing controller 160 configured to control the scan driver 120 and the data driver 130, and a power circuit 170.

The display panel 110 may include a substrate 111 and an opposite substrate 112. The opposite substrate 112 may be an encapsulation substrate. The substrate 111 may include a plastic film or a glass substrate, but embodiments of the disclosure are not limited thereto. For example, the substrate 111 may comprise a semiconductor material, such as a silicon wafer. The opposite substrate 112 may be a plastic film, a glass substrate, or an encapsulation film (or protective film).

The display panel 110 includes a display area DA and a non-display area NDA surrounding the display area DA. The display panel 110 includes pixels P provided in the display area DA to display an image. Each of the pixels P may include a plurality of subpixels SP. The structure of the subpixel SP may be variously changed according to the type of the light emitting display apparatus 100. For example, the subpixels SP may be formed in a top emission type, a bottom emission type, or a dual emission type according to the structure. The subpixels SP indicate a unit capable of forming a color filter of a specific type or capable of emitting a color of itself without forming a color filter. The subpixels SP may have one or more other light-emitting areas according to light-emitting characteristics. For example, the plurality of subpixels SP may be arranged in a quad type or a stripe type, but embodiments of the present disclosure are not limited thereto. The color type, arrangement type, arrangement order, and the like of the subpixels SP may be configured in various forms according to the light-emitting characteristics, lifespan of the apparatus, spec of the apparatus, and the like.

The display panel 110 may include data lines DL and scan lines SL (or gate lines) connected to the subpixels SP. The data lines DL may be arranged to cross the scan lines SL. Each of the subpixels SP of the display panel 110 may be connected to any one of the data lines DL and any one of the scan lines SL. The data lines DL may supply a data voltage supplied from the data driver 130 to each of the subpixels SP. The scan lines SL may supply a scan signal supplied from the scan driver 120 to each of the subpixels SP.

Each of the subpixels SP is turned-on by the scan signal. When the data voltage of the data line DL is supplied to a gate electrode of a driving transistor, a light emitting element may emit light according to a drain-to-source current of the driving transistor. The scan driver 120 may receive a scan control signal GCS from the timing controller 160. The scan driver 120 may supply the scan signals or emission control signal to the scan lines SL by using the scan control signal GCS.

The scan driver 120 may be configured in a gate driver in panel (GIP) manner in the non-display area NDA outside one side or both sides of the display area DA. Alternatively, the scan driver 120 may be manufactured as a driving chip, mounted on a flexible film, and attached to the non-display area NDA outside one side or both sides of the display area DA in a tape automated bonding (TAB) manner.

The data driver 130 may receive digital video data DATA and a data control signal DCS from the timing controller 160. The data driver 130 converts the digital video data DATA into analog positive/negative data voltages by using the data control signal DCS and supplies the analog positive/negative data voltages to the data lines DL.

The data driver 130 may include a plurality of source drive ICs (source drive integrated circuits). Each source drive IC may be mounted on a source film 140 using methods such as COF (Chip On Film), COP (Chip On Plastic), FPC (Flexible Printed Circuit), or FFC (Flexible Flat Cable). One side of the source film 140 may be electrically connected to the display panel 110, and COF wiring may be disposed on the top of the source film 140 to electrically connect each source drive IC to the display panel 110. The source film 140 may be attached to the pads provided in the non-display area NDA of the display panel 110 using an anisotropic conductive film, allowing each source drive IC to be connected to the pads.

The display panel 110 may include a circuit board 150 for electrical connection between the data driver 130 and other devices. The circuit board 150 may include at least one component, but embodiments of the disclosure are not limited thereto.

The circuit board 150 may be attached to source films 140. The circuit board 150 may include one or more circuits implemented by driving chips. For example, the timing controller 160 may be mounted on the circuit board 150. The circuit board 150 may be a printed circuit board (PCB) or a flexible printed circuit board (FPCB).

The timing controller 160 receives digital video data DATA and timing signals from a host system. The timing signals may include a vertical synchronization signal, a horizontal synchronization signal, a data enable signal, a dot clock, and the like. The vertical synchronization signal is a signal defining one frame period. The horizontal synchronization signal is a signal defining one horizontal period required for supplying the data voltages to the pixels of one horizontal line of the display panel 110. The data enable signal defines a period in which valid data is input. The dot clock is a signal repeated at a predetermined short period.

The timing controller 160 may generate the data control signal DCS for controlling an operation timing of the data driver 130 and the scan control signal GCS for controlling an operation timing of the scan driver 120 based on the timing signals. The timing controller 160 may output the scan control signal GCS to the scan driver 120 and output the digital video data DATA and data control signal DCS to the data driver 130.

The power circuit 170 may generate and supply a plurality of driving voltages required for an operation of all circuit configurations of the light emitting display apparatus by using an input voltage. The power circuit 170 may generate a first power voltage EVDD (or driving power voltage), a second power voltage EVSS (or common power voltage) and a reference power voltage (Vref) (or reference voltage) and supply the generated voltages to the display panel 110. The power circuit 170 may generate and supply various driving voltages required for operations of the gate driver 120, the data driver 130, and the timing controller 160.

In order to provide a touch sensing function, the light emitting display apparatus of an embodiment of the disclosure may further include a touch panel TSP including a plurality of touch electrodes TE, and a touch sensing circuit 200 configured to supply a touch driving signal to the touch panel TSP, detect a touch sensing signal from the touch panel TSP, and sense whether a user has touched the touch panel TSP or a touch position (or touch coordinates) on the touch panel TSP based on the detected touch sensing signal.

The touch sensing circuit 200 may include a touch driving circuit 210 configured to supply a touch driving signal to the touch panel TSP and detect a touch sensing signal from the touch panel TSP, and a touch controller 220 configured to sense whether a user has touched the touch panel TSP or a touch position on the touch panel TSP based on the touch sensing signal detected by the touch driving circuit 210. The touch driving circuit 210 may supply a touch driving signal to the touch panel TSP and detect a touch sensing signal from the touch panel TSP.

The touch driving circuit 210 and the touch controller 220 may be implemented as separate components or may be integrated into a single component, but embodiments of the disclosure are not limited thereto.

For example, each of the scan driver 120 (or gate driver), the data driver 130, and the touch driving circuit 210 may be implemented as one or more integrated circuits, and in terms of electrical connection with the display panel 110, may be implemented using methods such as COG (Chip On Glass), COF (Chip On Film), COP (Chip On Plastic), or TCP (Tape Carrier Package). The scan driver 120 may also be implemented using a GIP (Gate Driver In Panel) method.

For example, each of the circuit configurations for display driving 120, 130 and 160 and the circuit configurations for touch sensing 210 and 220 may be implemented as one or more separate components. For instance, one or more of the circuit configurations for display driving 120, 130 and160 and one or more of the circuit configurations for touch sensing 210 and 220 may be functionally integrated and implemented as one or more components.

For example, the data driver 130 and the touch driving circuit 210 may be integrated and implemented in one or more integrated circuit chips. When the data driver 130 and the touch driving circuit 210 are integrated and implemented in two or more integrated circuit chips, each of the integrated circuit chips may have both a data driving function and a touch driving function.

The touch panel TSP may include a plurality of touch electrodes TE to which a touch driving signal may be applied or from which a touch sensing signal may be detected, and a plurality of touch routing lines configured to connect the plurality of touch electrodes TE to the touch driving circuit 210.

The touch panel TSP may be configured outside the display panel 110. In this case, the touch panel TSP and the display panel 110 may be separately manufactured and then bonded together, and such the touch panel TSP may be referred to as an external type or an add-on type. Alternatively, the touch panel TSP may be embedded inside the display panel 110. In this case, when manufacturing the display panel 110, the plurality of touch electrodes and the plurality of touch routing lines constituting the touch panel TSP may be formed together with the plurality of electrodes and signal lines for display driving as a touch sensor structure.

The touch panel TSP of an embodiment of the disclosure may be configured as a Touch on Encapsulation (ToE) structure directly formed on an encapsulation portion ENC of the display panel 110 during manufacturing of the display panel. For example, the touch panel TSP may be formed by patterning at least one inorganic insulating layer and touch electrodes TE on the encapsulation portion ENC, and connecting them to signal lines formed as electrodes for display driving.

Referring to FIG. 3, the display area DA of the display panel 110 may have the plurality of subpixels SP arranged on an upper surface of the substrate 111, and the encapsulation portion ENC configured to prevent external moisture or oxygen from penetrating into circuit elements of the subpixels SP disposed in the display panel 110 may be disposed on the upper part of the display panel 110.

The touch panel TSP of an embodiment of the disclosure may be disposed on the encapsulation portion ENC of the display panel 110. For example, a touch sensor structure including the plurality of touch electrodes TE constituting the touch panel TSP may be disposed on the encapsulation portion ENC. The plurality of touch electrodes TE may be also called touch electrode array.

During touch sensing, a touch driving signal or a touch sensing signal may be applied to the touch electrodes TE. Accordingly, the distance between the touch electrodes TE and the cathode, which are disposed with the encapsulation portion ENC therebetween, may be designed to have a predetermined value considering the display panel thickness, display panel manufacturing process, and display performance. For example, the thickness of the encapsulation portion ENC may be designed to be at least 1 µm.

The touch panel TSP of an embodiment of the disclosure may employ a capacitance-based touch sensing method, sensing touch based on mutual capacitance or self capacitance, but embodiments of the disclosure are not limited thereto.

The mutual capacitance-based touch sensing method may include a plurality of touch electrodes TE classified into driving touch electrodes (transmitting touch electrodes) to which touch driving signals are applied, and sensing touch electrodes (receiving touch electrodes) that detect touch sensing signals and form capacitance with the driving touch electrodes. For example, in the mutual capacitance-based touch sensing method, the touch sensing circuit 200 may sense touch presence or touch coordinates based on changes in capacitance (mutual capacitance) between driving touch electrodes and sensing touch electrodes according to the presence or absence of a pointer such as a finger or pen.

In the self capacitance-based touch sensing method, each touch electrode TE functions as both a driving touch electrode and a sensing touch electrode. That is, the touch sensing circuit 200 may apply a touch driving signal to one or more touch electrodes TE, detect a touch sensing signal through the touch electrodes TE to which the touch driving signal is applied, and sense touch presence or touch coordinates based on changes in capacitance between a pointer such as a finger or pen and the touch electrodes TE according to the detected touch sensing signal. In the self capacitance-based touch sensing method, there is no distinction between driving touch electrodes and sensing touch electrodes.

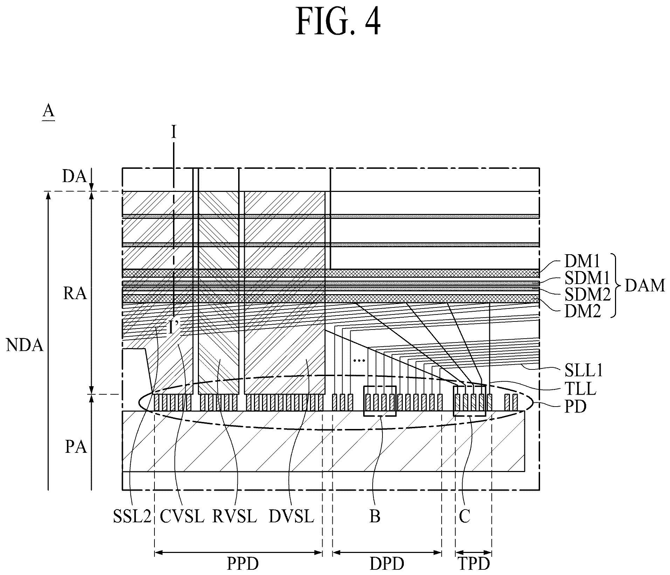

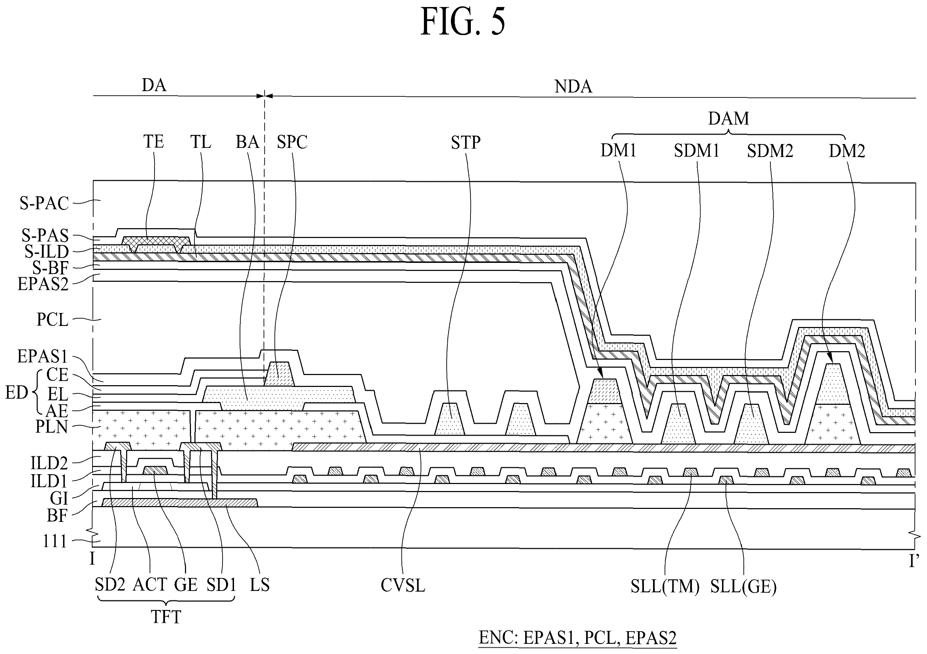

FIG. 4 illustrates a region A shown in FIG. 2 of an embodiment of the disclosure. FIG. 5 is a cross-sectional view taken along line I-I' of FIG. 4 of an embodiment of the disclosure.

Referring to FIGS. 4 and 5, the display panel 110 of an embodiment of the disclosure may include a display area DA for displaying images and a non-display area NDA at least partly surrounding the display area DA. The non-display area NDA may include a plurality of dam patterns DAM. The non-display area NDA may include a pad area PA and a routing area RA. The routing area RA may be arranged between the display area and the pad area PA. The pad area PA and the routing area RA both belong to the non display area NDA:

The pad area PA may be disposed at one end of the display panel 110 and may include a plurality of pads PD to which external signals are applied. A plurality of pads PD may be exposed to the outside without being covered by an insulating layer and may be connected to the source film 140. For example, the source film 140 may include a source drive IC of the data driver 130 mounted thereon, and COF wiring electrically connecting the source drive IC to the plurality of pads PD may be disposed. Also, the source film 140 may include COF wiring disposed to transmit the driving control signals and driving power voltages supplied from the circuit board 150. The source film 140 may be attached to the plurality of pads PD arranged in the pad area PA using an anisotropic conductive film, and may electrically connect each pad PD to the COF wiring.

The plurality of pads PD may include power pads PPD to which various driving power voltages are applied, display pads DPD to which control voltage signals related to display driving are applied, and touch pads TPD to which touch driving signals and touch sensing signals related to touch driving are applied. For example, the power pads PPD may include a first power pad to which a first power voltage EVDD (or driving power voltage) supplied from the power circuit 170 is applied, a second power pad to which a second power voltage EVSS is applied, and a reference power pad to which a reference power voltage Vref is applied. Also, the display pads DPD may include a data signal pad to which a data signal is applied and a gate driving pad to which a scan control signal for controlling the scan driver 120 is applied, but embodiments of the present disclosure are not limited thereto.

The routing area RA may be disposed between the pad area PA and the display area DA, and may include power voltage shorting lines DVSL, RVSL and CVSL, and various signal link lines SLL1, SLL2 and TLL or these lines or part thereof pass through the routing area RA.

The power voltage shorting lines DVSL, RVSL and CVSL may be connected to power pads disposed in the pad area PA and may extend to the display area DA. The power voltage shorting lines DVSL, RVSL and CVSL may extend in a first direction (or X-axis direction) and a second direction (or Y-axis direction), or may extend in the second direction. For example, the power voltage shorting lines DVSL, RVSL and CVSL may include a first power voltage shorting line DVSL, a second power voltage shorting line CVSL, and a reference voltage shorting line RVSL. For example, the first power voltage shorting line DVSL and the reference voltage shorting line RVSL may extend in the second direction, and the second power voltage shorting line CVSL may extend in the second direction and then be bent and extended in the first direction, but embodiments of the disclosure are not limited thereto. So, they may also run in an angled direction or inclined in the routing area RA.

The signal link lines SLL1, SLL2 and TLL may be connected to the display pads DPD and the touch pads TPD disposed in the pad area PA, and may extend toward the display area DA. The signal link lines SLL1, SLL2 and TLL may extend in a first direction, a second direction, or a third direction (or a diagonal direction) between the first direction and the second direction.

The signal link lines SLL1, SLL2 and TLL may include display driving link lines SLL1 and SLL2 (hereinafter, it may also be referred to as display driving link lines SLL) connected to the scan driver 120 and to data lines DL disposed in the display area DA, and touch driving link lines TLL connected to touch lines TL and touch electrodes TE disposed in the display area DA.

The display driving link lines SLL1 and SLL2 may extend in the third direction toward a right side or a left side according to the positions where they are connected to the pad area PA. For example, the display driving link lines SLL1 and SLL2 may include a gate control link line SLL1 and a data signal link line SLL2. The gate control link line SLL1 may be connected to the left side or the right side of the pad area PA in the first direction (or X-axis direction), and may extend to a left or right edge of the display area DA where the scan driver 120 is located. The data signal link line SLL2 may be connected to a center of the pad area PA and may radially extend to be evenly distributed in the display area DA.

The touch driving link line TLL may extend to be connected to the touch electrodes TE and the touch lines TL disposed in the display area DA, and may overlap with the display driving link lines SLL1 and SLL2 in the routing area RA.

The display driving link lines SLL1 and SLL2 may be disposed to overlap with the power voltage shorting lines DVSL, RVSL and CVSL in the routing area RA. For example, the display driving link lines SLL1 and SLL2 may be disposed to cross below the power voltage shorting lines DVSL, RVSL and CVSL. Also, the touch driving link line TLL may be disposed to cross above the power voltage shorting lines DVSL, RVSL and CVSL.

The display panel 110 of an embodiment of the disclosure may include an encapsulation portion ENC. The encapsulation portion ENC may be disposed in the display area DA and may be configured to cover the entire display area DA. The encapsulation portion ENC may extend from the display area DA toward the pad area PA. The encapsulation portion ENC may be disposed so as not to overlap the pad area PA, allowing the plurality of pads PD disposed in the pad area PA to be exposed to the outside for being connected to other components. For example, the encapsulation portion ENC may be disposed in the display area DA and the routing area RA. As the encapsulation portion ENC includes a plurality of layers (EPAS1, PCL und EPAS2), it might be possible that only part of the sub layers of the encapsulation portion ENC runs through routing area RA, e.g. as shown in Fig, 5 only the first and second inorganic layer of the encapsulation portion ENC are extended through the routing area in the area whether DAMs are provided.

The display driving link lines SLL1 and SLL2 of an embodiment of the disclosure may have one end connected to the display pads DPD and the other end connected to the scan driver 120 and the data lines DL disposed in the display area DA. The display driving link lines SLL1 and SLL2 may be disposed in the routing area RA between the pad area PA and the display area DA. The touch driving link line TLL may be disposed to overlap the display driving link lines SLL1 and SLL2 in the routing area RA of the non-display area NDA.

The encapsulation portion ENC of an embodiment of the disclosure may serve to prevent electrical interference and shorts between the display driving link lines SLL1 and SLL2 formed first during the thin film transistor formation process and the touch driving link line TLL formed in a subsequent touch on encapsulation (ToE) process. For example, the touch driving link line TLL may be disposed above the encapsulation portion ENC that covers the display driving link lines SLL1 and SLL2. Also, the touch electrodes TE and the touch lines TL may be disposed above the encapsulation portion ENC in the display area DA.

The plurality of dam patterns DAM may be disposed to surround the periphery of the display area DA. The plurality of dam patterns DAM may be disposed in the routing area RA between the pad area PA and the display area DA. The plurality of dam patterns DAM may overlap with the power voltage shorting lines DVSL, RVSL and CVSL and the signal link lines SLL1, SLL2 and TLL. The plurality of dam patterns DAM may serve to block the flow of an organic layer PCL composing the encapsulation portion ENC.

The plurality of dam patterns DAM may comprise one or more organic materials. The plurality of dam patterns DAM may include a first dam pattern DM1, which is adjacent to the display area DA and comprises a plurality of organic materials, and a second dam pattern DM2, which is adjacent to the pad area PA and comprises a plurality of organic materials. Also, the plurality of dam patterns DAM may further include sub-dam patterns SDM1 and SDM2, which are disposed between the first dam pattern DM1 and the second dam pattern DM2 and comprise at least one organic material.

Referring to FIG. 5, the display panel 110 of an embodiment of the disclosure may include a substrate 111 having the display area DA and the non-display area NDA, at least one insulating layer disposed on the substrate 111, the power voltage shorting lines CVSL, at least one thin film transistor TFT, a light emitting device ED, the encapsulation portion ENC, a touch encapsulation or insulation layer S-BF and S-ILD (or inorganic insulating layers) disposed on the encapsulation portion ENC, and a touch sensor array TE and TL (or a touch electrode array).

The substrate 111 may include a transparent or opaque plastic film or a glass substrate. For example, the substrate 111 may have the at least one thin film transistor TFT and the light emitting device ED to be disposed thereon, and may be an array substrate or a first substrate, but embodiments of the present disclosure are not limited thereto.

At least one insulating layer BF, GI, ILD1 and ILD2 may be disposed on the substrate 111. For example, a buffer layer BF may be disposed on the substrate 111. The buffer layer BF may be disposed over the entire surface of the substrate 111, may be configured to cover a light blocking layer LS disposed on the substrate 111, and may serve to block foreign substances or moisture penetrating through the substrate 111.

A gate insulating layer GI, first and second interlayer insulating layers ILD1 and ILD2, and at least one thin film transistor TFT may be disposed on the buffer layer BF. For example, the at least one insulating layer BF, GI, ILD1 and ILD2 may be formed as a single layer or a multilayer including an inorganic insulating material such as silicon oxide (SiOX), silicon nitride (SiNX), or aluminum oxide (Al2O3), but embodiments of the present disclosure are not limited thereto.

The thin film transistor TFT may be disposed on the buffer layer BF in the display area DA. The thin film transistor TFT may comprise an active layer ACT, a gate electrode GE, and source/drain electrodes SD1 and SD2 (hereinafter, it may also be referred to as source/drain electrodes SD).

The active layer ACT may be disposed on the buffer layer BF and may comprise a semiconductor material based on an oxide semiconductor such as IGZO (indium-gallium-zinc-oxide), or a semiconductor material based on silicon, such as amorphous silicon or polycrystalline silicon, but embodiments of the present disclosure are not limited thereto. The active layer ACT may include a source region, a drain region, and a channel region between the source and drain regions.

The gate insulating layer GI may be patterned and formed only on the channel region of the active layer ACT, or may be disposed over the entire buffer layer BF including the active layer ACT.

The gate electrode GE may be disposed on the gate insulating layer GI to overlap with the channel region of the active layer ACT, and may be patterned together with the gate insulating layer GI. The gate electrode GE may be formed of the same material in the same layer as the scan line SL disposed in the display area DA. For example, the gate electrode GE may be formed of the same material in the same layer as the display driving link lines SLL1 and SLL2 disposed in the non-display area NDA, but embodiments of the present disclosure are not limited thereto. For example, a portion of the display driving link lines SLL1 and SLL2 may be formed of the same material in the same layer as the gate electrode GE.

A first interlayer insulating layer ILD1 may be disposed on the gate insulating layer GI and the gate electrode GE, and an intermediate metal layer TM may be disposed on the first interlayer insulating layer ILD1. The intermediate metal layer TM may be formed as a connection pattern (or jumper pattern) connecting the gate electrode pattern and the source/drain electrode pattern between the gate electrode GE and the source/drain electrodes SD1 and SD2, or may be formed as a part of an electrode included in a storage capacitor. For example, the intermediate metal layer TM may be formed of the same material in the same layer as the display driving link lines SLL1 and SLL2 disposed in the non-display area NDA, but embodiments of the disclosure are not limited thereto. For example, a portion of the display driving link lines SLL1 and SLL2 may be formed of the same material in the same layer as the intermediate metal layer TM. Also, the display driving link lines SLL1 and SLL2 may include a first display driving link line formed of the same material in the same layer as the gate electrode GE and a second display driving link line formed of the same material in the same layer as the intermediate metal layer TM, which are overlapped with each other to form a single signal line, but embodiments of the disclosure are not limited thereto.

In the non-display area NDA, the display driving link lines SLL1 and SLL2 may be disposed on the gate insulating layer GI and the first interlayer insulating layer ILD1. For example, the display driving link lines SLL1 and SLL2 may be disposed in the routing area RA between the display area DA and the pad area PA. The display driving link lines SLL1 and SLL2 may include a first display driving link line formed of the same material as the gate electrode GE on the gate insulating layer GI and a second display driving link line formed of the same material as the intermediate metal layer TM on the first interlayer insulating layer ILD1. The first and second display driving link lines may be alternately disposed or may be disposed to overlap each other, but embodiments of the disclosure are not limited thereto.

The second interlayer insulating layer ILD2 may be disposed on the first interlayer insulating layer ILD1 and the intermediate metal layer TM, and the source/drain electrodes SD1 and SD2 may be disposed on the second interlayer insulating layer ILD2. The source/drain electrodes SD1 and SD2 may include a first source/drain electrode SD1 and a second source/drain electrode SD2. For example, the first source/drain electrode SD1 may be electrically connected to a first region (source or drain region) of the active layer ACT. Also, the first source/drain electrode SD1 may be electrically connected to the light blocking layer LS on the substrate 111. The second source/drain electrode SD2 may be electrically connected to a second region (source or drain region) of the active layer ACT. For example, the source/drain electrodes SD1 and SD2 may be formed of the same material in the same layer as the power voltage shorting lines DVSL, RVSL and CVSL disposed in the non-display area NDA, but embodiments of the present disclosure are not limited thereto. Also, the source/drain electrodes SD1 and SD2 may be formed of the same material in the same layer as pad electrodes of the plurality of pads PD disposed in the pad area PA. For example, the pad electrodes disposed in the pad area PA may be formed of the same material in the same layer as the source/drain electrodes SD1 and SD2.

In the non-display area NDA, the power voltage shorting lines DVSL, RVSL and CVSL may be disposed on the second interlayer insulating layer ILD2. For example, the power voltage shorting lines DVSL, RVSL and CVSL may be disposed in the routing area RA between the display area DA and the pad area PA. The power voltage shorting lines DVSL, RVSL and CVSL may be formed of the same material as the source/drain electrodes SD1 and SD2 on the second interlayer insulating layer ILD2, but embodiments of the present disclosure are not limited thereto.

In the non-display area NDA, pad electrodes of the plurality of pads PD may be disposed on the second interlayer insulating layer ILD2. For example, the pad electrodes may be disposed in the pad area PA. The pad electrodes may be formed of the same material as the source/drain electrodes SD1 and SD2 on the second interlayer insulating layer ILD2, but embodiments of the present disclosure are not limited thereto.

A planarization layer PLN may be disposed on the second interlayer insulating layer ILD2 in the display area DA. The planarization layer PLN may serve to planarize step differences caused by the thin-film transistor TFT, the scan line SL, and the data line DL disposed on the substrate 111, and may be formed of an organic insulating material. For example, the planarization layer PLN may be formed of an organic material such as acryl resin, epoxy resin, phenolic resin, polyamide resin, or polyimide resin, but embodiments of the present disclosure are not limited thereto.

A light emitting device ED comprising a pixel electrode AE, an emission layer EL, and a common electrode CE may be disposed on the planarization layer PLN in the display area DA. Also, a bank layer BA configured to define an opening area (or an emission area) of the pixel electrode AE may further be disposed on the planarization layer PLN. For example, the bank layer BA may be configured to cover an edge of the pixel electrode AE. The bank layer BA may be disposed between the pixel electrode AE and the emission layer EL. Meanwhile, a spacer SPC may be further disposed on the bank layer BA. The spacer SPC may serve to maintain a gap between the light emitting device ED and the encapsulation portion ENC in the display area DA, and may support the encapsulation portion ENC, but embodiments of the present disclosure are not limited thereto.

The encapsulation portion ENC may be disposed on the light emitting device ED and the bank layer BA to protect the light emitting device ED. The encapsulation portion ENC may be disposed to cover the entire display area DA so as to sufficiently cover the light emitting device ED, and may extend to be disposed over at least a portion of the non-display area NDA. For example, the encapsulation portion ENC may extend to the non-display area NDA, excluding the pad area PA, and may be disposed to overlap with the power voltage shorting lines DVSL, RVSL and CVSL and the display driving link lines SLL1 and SLL2 disposed in the routing area RA of the non-display area NDA. In the routing area RA, the encapsulation portion ENC may be configured to cover the power voltage shorting lines DVSL, RVSL and CVSL and the display driving link lines SLL1 and SLL2.

The encapsulation portion ENC may include a first inorganic layer EPAS1, an organic layer PCL, and a second inorganic layer EPAS2. The first inorganic layer EPAS1 may be disposed on the common electrode CE of the light emitting device ED, the organic layer PCL may be disposed on the first inorganic layer EPAS1, and the second inorganic layer EPAS2 may be disposed on the organic layer PCL or the first inorganic layer EPAS1 to cover the organic layer PCL.

The first inorganic layer EPAS1 may be disposed on the substrate 111 where the common electrode CE is disposed, so as to be closest to the light emitting device ED. For example, the first inorganic layer EPAS1 may be formed of a low-temperature depositable inorganic insulating material such as silicon nitride (SiNX), silicon oxide (SiOx), silicon oxynitride (SiON), or aluminum oxide (Al2O3), but embodiments of the present disclosure are not limited thereto. The first inorganic layer EPAS1 may be deposited under a low-temperature atmosphere, thereby preventing damage to the light emitting device ED, which includes organic materials vulnerable to high-temperature conditions during deposition.

The organic layer PCL may be disposed with a smaller area than the first inorganic layer EPAS1, and the organic layer PCL may be configured to expose both ends of the first inorganic layer EPAS1. The organic layer PCL may serve as a buffer to relieve stress between the layers caused by bending of the light emitting display apparatus and may also serve to enhance planarization performance. For example, the organic layer PCL may be composed of an organic insulating material such as acrylic resin, epoxy resin, polyimide, polyethylene, or silicon oxycarbon (SiOC), but embodiments of the disclosure are not limited thereto. The organic layer PCL may be thicker than the first and second inorganic layers EPAS1, EPAS2.

The second inorganic layer EPAS2 may be disposed to cover the upper surfaces and side surfaces of the first inorganic layer EPAS1 and the organic layer PCL. The second inorganic layer EPAS2 may serve to minimize or block external moisture or oxygen from penetrating into the first inorganic layer EPAS1 and the organic layer PCL. For example, the second inorganic layer EPAS2 may be formed of an inorganic insulating material such as silicon nitride (SiNx), silicon oxide (SiOx), silicon oxynitride (SiON), or aluminum oxide (Al2O3), but embodiments of the present disclosure are not limited thereto.

The plurality of dam patterns DAM may be disposed in the non-display area NDA on the substrate 111. For example, the plurality of dam patterns DAM may be disposed in the routing area RA of the non-display area NDA. In the routing area RA, the plurality of dam patterns DAM may serve to block the flow of the organic layer PCL of the encapsulation portion ENC. For example, the plurality of dam patterns DAM may be disposed to surround the periphery of the display area DA to block the flow of the organic layer PCL of the encapsulation portion ENC. Accordingly, the organic layer PCL of the encapsulation portion ENC may be disposed from the display area DA to the non-display area NDA, where the plurality of dam patterns DAM are disposed. For example, the organic layer PCL may be disposed up to a portion of the routing area RA, and the first and second inorganic layers EPAS1 and EPAS2 may be disposed to extend to the end of the routing area RA. For example, the organic layer PCL and the first inorganic layer EPAS1 may be disposed up to a portion of the routing area RA, and the second inorganic layer EPAS2 may be disposed to extend to the end of the routing area RA, but embodiments of the present disclosure are not limited thereto.

The plurality of dam patterns DAM may be disposed to overlap the power voltage shorting lines DVSL, RVSL and CVSL and the display driving link lines SLL1 and SLL2. For example, at least a portion of the plurality of dam patterns DAM may be disposed on the power voltage shorting lines DVSL, RVSL and CVSL. The plurality of dam patterns DAM and the power voltage shorting lines DVSL, RVSL and CVSL may be disposed to intersect each other.

The plurality of dam patterns DAM may include a first dam pattern DM1 adjacent to the display area DA and a second dam pattern DM2 adjacent to the pad area PA. Also, the plurality of dam patterns DAM may include at least one sub-dam pattern SDM1 and SDM2 disposed between the first and second dam patterns DM1 and DM2. Meanwhile, the non-display area NDA may further include at least one stopper STP disposed between the display area DA and the first dam pattern DM1. The at least one stopper STP may serve to block the flow of the organic layer PCL of the encapsulation portion ENC, but embodiments of the present disclosure are not limited thereto.

The first dam pattern DM1 may contact the first inorganic layer EPAS1, the organic layer PCL, and the second inorganic layer EPAS2 of the encapsulation portion ENC. The second dam pattern DM2 and the at least one sub-dam pattern SDM1 and SDM2 may contact at least one of the first and second inorganic layers EPAS1 and EPAS2 of the encapsulation portion ENC. For example, the second dam pattern DM2 and the at least one sub-dam pattern SDM1 and SDM2 may contact the first inorganic layer EPAS1 or the second inorganic layer EPAS2, but embodiments of the present disclosure are not limited thereto.

The plurality of dam patterns DAM may comprise at least a portion of the planarization layer PLN, the bank layer BA, and the spacer SPC. For example, the first dam pattern DM1 may comprise the planarization layer PLN and the spacer SPC, and the second dam pattern DM2 may comprise the planarization layer PLN and the bank layer BA. Also, at least one of the sub-dam patterns SDM1 and SDM2 may comprise the bank layer BA, but embodiments of the present disclosure are not limited thereto.

A touch encapsulation layer S-BF and S-ILD (or an inorganic insulating layer) may be disposed on the encapsulation portion ENC. For example, the touch encapsulation layer S-BF and S-ILD may include a touch buffer layer S-BF and a touch insulating layer S-ILD, and the touch buffer layer S-BF may be disposed on the encapsulation portion ENC, preferably directly disposed thereon. The touch buffer layer S-BF may be disposed between the touch sensor array TE and TL (or the touch electrode array) and the encapsulation portion ENC. For example, the touch buffer layer S-BF may be omitted, and the touch sensor array TE and TL may be directly disposed on the encapsulation portion ENC, but embodiments of the disclosure are not limited thereto.

Touch lines TL of the touch sensor array TE and TL may be disposed on the touch buffer layer S-BF. For example, the touch line TL may be formed in a single-layer or multi-layer structure including a metal having strong corrosion resistance and acid resistance, such as aluminum (Al), titanium (Ti), copper (Cu), or molybdenum (Mo), but embodiments of the disclosure are not limited thereto. The touch line TL may be integrally formed with the touch driving link line TLL disposed in the non-display area NDA.

In the non-display area NDA, the touch driving link line TLL may be disposed on the touch buffer layer S-BF, and the touch driving link line TLL may extend toward the pad area PA. For example, the touch driving link line TLL may coincide with one end of the touch buffer layer S-BF. For example, the touch buffer layer S-BF may coincide with an end of the touch driving link line TLL or may extend beyond the end of the touch driving link line TLL.

The touch line TL and the touch driving link line TLL may be formed together in the ToE (Touch on Encapsulation) process and may be formed of the same material in the same layer.

The touch insulating layer S-ILD may be disposed on the touch line TL and the touch driving link line TLL. For example, the touch insulating layer S-ILD may be formed using an organic film or an inorganic film that may be formed by a low-temperature process. When an organic film is used as the touch insulating layer S-ILD, after being coated on the substrate 111, the touch insulating layer S-ILD may be formed by curing at a temperature of 100 degrees Celsius or less to prevent damage to the light emitting device ED, which is vulnerable to high temperatures. The touch insulating layer S-ILD in an embodiment of the disclosure may use an inorganic film, and a multilayer structure of the touch insulating layer S-ILD may be formed by repeating a low-temperature CVD deposition process and a cleaning process at least twice to prevent damage to the light emitting device ED, which is vulnerable to high temperatures.

In the display area DA, a portion of the touch insulating layer S-ILD may be selectively removed to form a contact hole connected to the touch electrode TE, and the touch electrode TE may be disposed on the touch insulating layer S-ILD. The touch electrode TE may be electrically connected to the touch line TL through the contact hole formed in the touch insulating layer S-ILD.

Touch protective layers S-PAS and S-PAC may be additionally disposed on the touch insulating layer S-ILD and the touch electrode TE. For example, the touch protective layers S-PAS and S-PAC may include a first touch protective layer S-PAS formed of inorganic material and a second touch protective layer S-PAC formed of organic material, but embodiments of the disclosure are not limited thereto. For example, the touch protective layers S-PAS and S-PAC may be disposed on at least a portion of an area excluding the pad area PA in the non-display area NDA. For example, the touch protective layers S-PAS and S-PAC may be disposed in the routing area RA in the non-display area NDA.

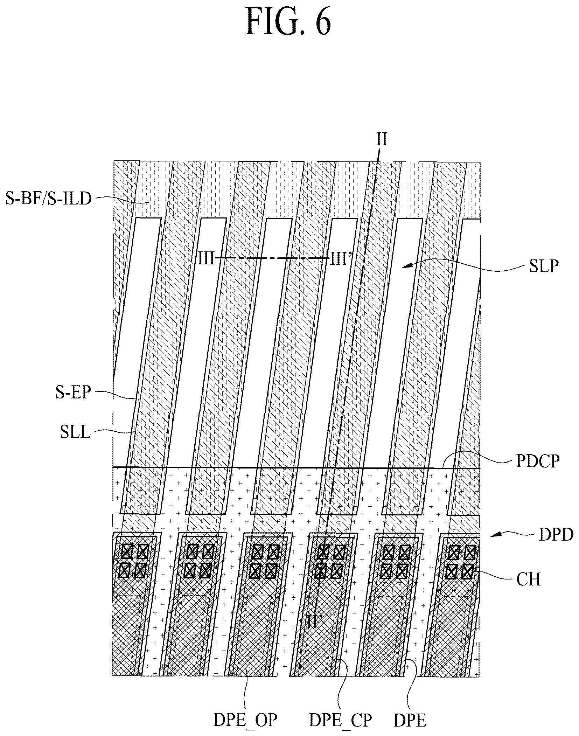

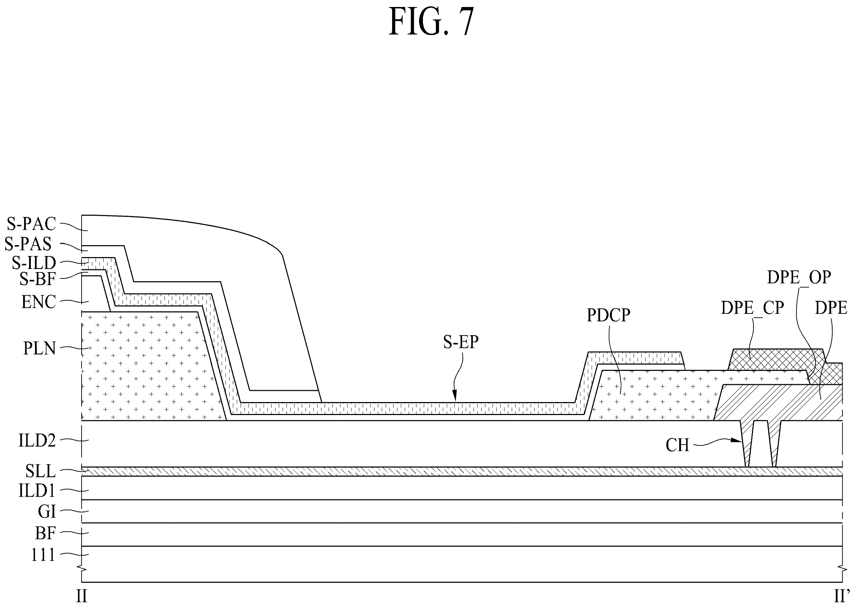

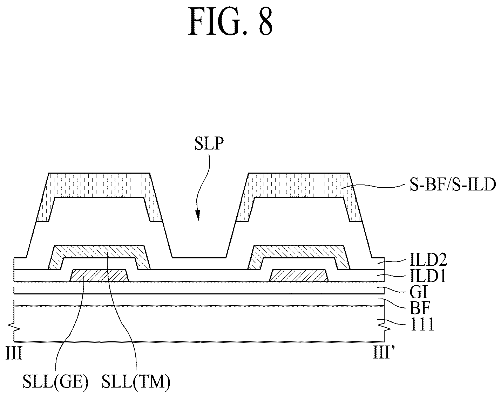

FIG. 6 illustrates a region B shown in FIG. 4 of an embodiment of the disclosure. FIG. 7 is a cross-sectional view taken along line II-II' of FIG. 6 of an embodiment of the disclosure. FIG. 8 is a cross-sectional view taken along line III-III' of FIG. 6 of an embodiment of the disclosure.

Referring to FIGS. 6 to 8, the pad area PA of an embodiment of this disclosure may include a display driving link line SLL and a display pad DPD.

The display driving link line SLL may be connected to a data line DL or a scan driver 120 disposed in the display area DA. For example, the display driving link line SLL may be formed of the same material in the same layer as the scan line SL or data line DL, and may be integrally extended without interruption from the display area DA to the pad area PA.

The display driving link line SLL may be formed in a stacked structure of two or more layers according to the layered structure of the data line DL, scan line SL, or power voltage line disposed in the display area DA, or may be formed in such a manner that it is located in different layers depending on the regions. For example, each display driving link line SLL may be formed of the same material in the same layer as the gate electrode GE, or may be formed of the same material in the same layer as the middle metal layer TM. For example, as shown in FIG. 8, the display driving link line SLL may be formed of the same material on the same layer as the middle metal layer TM on the first interlayer insulating layer ILD1. Alternatively, the display driving link line SLL may be formed of the same material on the same layer as the gate electrode GE on the gate insulating layer GI, but embodiments of the disclosure are not limited thereto.

The display driving link line SLL may include a first display driving link line formed of the same material as the gate electrode GE and a second display driving link line formed of the same material as the intermediate metal layer TM, which may be alternately disposed. For example, as shown in FIG. 8, each display driving link line SLL may include a first display driving link line formed of the same material as the gate electrode GE on the gate insulating layer GI, and a second display driving link line formed of the same material as the intermediate metal layer TM on the first interlayer insulating layer ILD1. The first and second display driving link lines may overlap to form a single signal line, but embodiments of the disclosure are not limited thereto.

The display pad DPD may include a plurality of display pad electrodes DPE electrically connected to each display driving link line SLL, a pad cover portion PDCP covering at least a part of the plurality of display pad electrodes DPE, an opening pattern DPE_OP formed in the pad cover portion PDCP to expose another part of each display pad electrode DPE, and a display connection pad electrode DPE_CP disposed on the pad cover portion PDCP, overlapping at least a part of the display pad electrodes DPE, and electrically connected to the display pad electrodes DPE through the opening pattern DPE_OP.

The plurality of display pad electrodes DPE may be configured to correspond to each display driving link line SLL, and may be formed together in an array process that forms the data lines DL, the scan lines SL, or the pixel circuits of the display area DA.

The plurality of display pad electrodes DPE may be disposed on the second interlayer insulating layer ILD2. Each display pad electrode DPE may be formed of the same material in the same layer as the source/drain electrode SD on the second interlayer insulating layer ILD2. For example, the plurality of display pad electrodes DPE may overlap the display driving link line SLL with the second interlayer insulating layer ILD2 therebetween. Each display pad electrode DPE may be electrically connected to the display driving link line SLL through a contact hole CH passing through the second interlayer insulating layer ILD2.

The pad cover portion PDCP may be configured to cover at least some of the plurality of display pad electrodes DPE. The pad cover portion PDCP may be formed of an organic insulating material. For example, the pad cover portion PDCP may be formed of the same material in the same layer as the planarization layer PLN disposed in the display area DA. The pad cover portion PDCP may be configured to have a height equal to or lower than that of the planarization layer PLN. For example, the pad cover portion PDCP may be configured to have a height lower than that of the planarization layer PLN.

The pad cover portion PDCP may be configured to cover a plurality of display pad electrodes DPE. For example, the pad cover portion PDCP may extend in a first direction (or X-axis direction) to cover the plurality of display pad electrodes DPE.

The pad cover portion PDCP may include an opening pattern DPE_OP that exposes a portion of each display pad electrode DPE. A portion of the upper surface of each display pad electrode DPE may be exposed through the opening pattern DPE_OP of the pad cover portion PDCP.

The display connection pad electrode DPE_CP may be disposed on the pad cover portion PDCP. The display connection pad electrode DPE_CP may be disposed to overlap each display pad electrode DPE. The display connection pad electrode DPE_CP may be electrically connected to each display pad electrode DPE through the opening pattern DPE_OP of the pad cover portion PDCP.

In an embodiment of the disclosure, the touch encapsulation layers S-BF and S-ILD (or inorganic insulating layer) may be disposed on the display driving link line SLL. For example, the touch encapsulation layers S-BF and S-ILD may be disposed on the second interlayer insulating layer ILD2, which covers the display driving link line SLL in the pad area PA. For example, the touch encapsulation layers S-BF and S-ILD may be disposed on the encapsulation portion ENC in the display area DA, and may be disposed on the second interlayer insulating layer ILD2 in the pad area PA. For example, the encapsulation portion ENC may extend from the non-display area NDA to an end of the routing area RA, and the touch encapsulation layers S-BF and S-ILD may be disposed on the second interlayer insulating layer ILD2 starting from the pad area PA where the encapsulation portion ENC is not disposed. The touch encapsulation layers S-BF and S-ILD may be at least partially removed in the pad area PA.

In an embodiment of the disclosure, the touch encapsulation layers S-BF and S-ILD may include an extension pattern portion S-EP configured to overlap at least a part of the pad cover portion PDCP disposed on the display pad DPD. For example, the extension pattern portion S-EP may be configured to overlap an end of the pad cover portion PDCP. So the extension pattern portion S-EP may extend from the routing area RA to the pad area PA. The extension pattern portion S-EP may be directly disposed on the second interlayer insulating layer ILD2. The extension pattern portion S-EP may be composed of the two inorganic insulating layers S-BF and S-ILD or only one of them. The extension pattern portion S-EP may be disposed from one side of the touch encapsulation layer S-BF and S-ILD to overlap with each display driving link line SLL. For example, the extension pattern portion S-EP may extend from one side of the touch encapsulation layer S-BF and S-ILD to overlap with each display driving link line SLL and reach the end of the pad cover portion PDCP. For example, each extension pattern portion S-EP may be formed as a finger pattern overlapping each display driving link line SLL.

Referring to FIG. 8, the extension pattern portion S-EP may include a slit pattern SLP formed between adjacent display driving link lines SLL. The slit pattern SLP may be formed by removing the touch encapsulation layer S-BF and S-ILD between adjacent display driving link lines SLL. For example, the slit pattern SLP may be formed by removing at least a portion of the touch encapsulation layer S-BF and S-ILD and the second interlayer insulating layer ILD2.

The extension pattern portion S-EP may be disposed on the pad cover portion PDCP to be spaced apart from the display connection pad electrode DPE_CP by a predetermined interval. For example, one end of the display connection pad electrode DPE_CP may be spaced apart from the extension pattern portion S-EP on the pad cover portion PDCP, the other end may extend toward the pad area PA, and may be electrically connected to the display pad electrode DPE exposed through the opening pattern DPE_OP of the pad cover portion PDCP.

In an embodiment of the disclosure, the extension pattern portion S-EP of the touch encapsulation layer S-BF and S-ILD has a slit pattern SLP, extends to overlap each display driving link line SLL, and is configured to overlap the end of the pad cover portion PDCP, thereby preventing damage or cracking defects of the inorganic layer covering the display driving link line SLL during the ToE (Touch on Encapsulation) process that follows the array process forming data lines DL, scan lines SL, or pixel circuits in the display area DA, and minimizing film lifting between the extension pattern portion S-EP having the slit pattern SLP and the pad cover portion PDCP. Accordingly, by improving moisture permeability reliability in the pad area PA, corrosion defects of the display driving link line SLL may be effectively prevented, and the light emitting display apparatus with enhanced reliability in high-temperature and high-humidity environments may be realized.

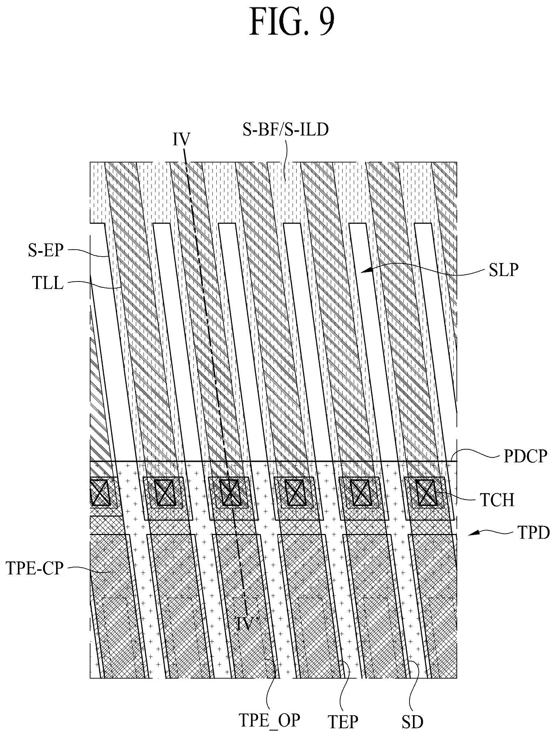

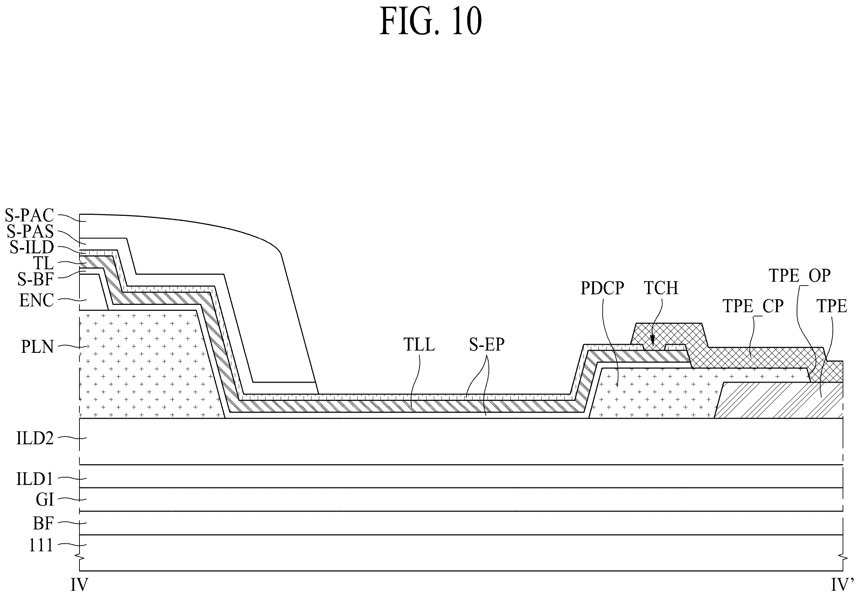

FIG. 9 illustrates a region C shown in FIG. 4 of another embodiment of the disclosure. FIG. 10 is a cross-sectional view taken along line IV-IV' of FIG. 9 of another embodiment of the disclosure.

Referring to FIGS. 9 and 10, the pad area PA of another embodiment of the disclosure may include a touch driving link line TLL and a touch pad TPD.

The touch driving link line TLL may be connected to the touch line TL disposed in the display area DA. For example, the touch driving link line TLL may be formed of the same material in the same layer as the touch line TL, and may be integrally extended without interruption from the display area DA to the pad area PA. The touch driving link line TLL may extend from the display area DA to the pad area PA and may be connected to the touch pad TPD.

The touch pad TPD may include a plurality of touch pad electrodes TPE electrically connected to each touch driving link line TLL, a pad cover portion PDCP covering at least a portion of the plurality of touch pad electrodes TPE, an opening pattern TPE_OP formed in the pad cover portion PDCP to expose another portion of each touch pad electrode TPE, and a touch connection pad electrode TPE_CP disposed on the pad cover portion PDCP, overlapping at least a portion of the touch pad electrode TPE, and electrically connected to the touch pad electrode TPE through the opening pattern TPE_OP.

The plurality of touch pad electrodes TPE may be configured to correspond to respective touch driving link lines TLL, and may be formed together in an array process for forming the data lines DL, the scan lines SL, or the pixel circuits in the display area DA.

A spacing between the plurality of touch pad electrodes TPE may be greater than a spacing between the plurality of display pad electrodes DPE. For example, in the display area DA, the number of data lines DL disposed for each subpixel SP may be greater than the number of touch lines TL, so that the plurality of display pad electrodes DPE may be disposed more densely than the plurality of touch pad electrodes TPE. For example, each touch pad electrode TPE may be disposed at equal intervals or may be arranged to be concentrated at the center, periphery, or locally in the pad area PA, but embodiments of the disclosure are not limited thereto.

The plurality of touch pad electrodes TPE may be disposed on the second interlayer insulating layer ILD2. Each touch pad electrode TPE may be formed of the same material as the source/drain electrode SD on the second interlayer insulating layer ILD2.

The pad cover portion PDCP may be configured to cover at least a portion of the plurality of touch pad electrodes TPE. The pad cover portion PDCP may be formed of an organic insulating material. For example, the pad cover portion PDCP may be formed of the same material in the same layer as the planarization layer PLN disposed in the display area DA. The pad cover portion PDCP may be configured to have a height equal to or lower than the planarization layer PLN. For example, the pad cover portion PDCP may be configured to have a height lower than the planarization layer PLN.

The pad cover portion PDCP may be configured to cover a plurality of touch pad electrodes TPE. For example, the pad cover portion PDCP may extend in a first direction (or X-axis direction) to cover the plurality of touch pad electrodes TPE.

The pad cover portion PDCP may include an opening pattern TPE_OP that exposes a portion of each touch pad electrode TPE. A portion of the upper surface of each touch pad electrode TPE may be exposed through the opening pattern TPE_OP of the pad cover portion PDCP.

The touch connection pad electrode TPE_CP may be disposed on the pad cover portion PDCP. The touch connection pad electrode TPE_CP may be arranged to overlap each touch pad electrode TPE. The touch connection pad electrode TPE_CP may be electrically connected to each touch pad electrode TPE through the opening pattern TPE_OP of the pad cover portion PDCP.

According to another embodiment of the disclosure, the touch driving link line TLL may be disposed between the touch buffer layer S-BF and the touch insulating layer S-ILD included in the touch encapsulation layer S-BF and S-ILD. That is, as shown in figure 10, the extension pattern portion S-EP may include the touch insulating layer S-ILD disposed above the touch driving link line and the touch buffer layer S-BF disposed below the touch driving link line TLL. For example, the touch buffer layer S-BF may be disposed on the second interlayer insulating layer ILD2 in the pad area PA. The touch buffer layer S-BF may be disposed on the encapsulation portion ENC in the display area DA, and may be disposed on the second interlayer insulating layer ILD2 in the pad area PA. For example, the encapsulation portion ENC may extend from the non-display area NDA to an end of the routing area RA, and the touch buffer layer S-BF may be disposed on the second interlayer insulating layer ILD2 in the pad area PA where the encapsulation portion ENC is not disposed.

The touch insulating layer S-ILD may be disposed on the touch driving link line TLL. For example, the touch insulating layer S-ILD may be configured to cover the touch driving link line TLL. For example, the touch insulating layer S-ILD may use an organic film or an inorganic film that can be formed by a low-temperature process. The touch insulating layer S-ILD may be formed of an inorganic insulating material, and a multilayer structure of the touch insulating layer S-ILD may be formed by repeating a low-temperature CVD deposition process and a cleaning process at least twice to prevent damage to the light emitting device ED vulnerable to high temperature. For example, in the display area DA, a portion of the touch insulating layer S-ILD may be selectively removed to form a contact hole passing through between the touch line TL and the touch electrode TE.

In another embodiment of the disclosure, the touch buffer layer S-BF, the touch driving link line TLL, and the touch insulating layer S-ILD may extend to overlap at least a portion of the pad cover portion PDCP disposed on the touch pad TPD. For example, the touch buffer layer S-BF, the touch driving link line TLL, and the touch insulating layer S-ILD may be configured to overlap the end of the pad cover portion PDCP.

The touch buffer layer S-BF and the touch insulating layer S-ILD disposed above and below each touch driving link line TLL may include a slit pattern SLP formed between adjacent touch driving link lines TLL. The slit pattern SLP may be formed by removing the touch buffer layer S-BF and the touch insulating layer S-ILD between adjacent touch driving link lines TLL. For example, the slit pattern SLP may be formed by removing at least a portion of the touch buffer layer S-BF, the touch insulating layer S-ILD, and the second interlayer insulating layer ILD2.

The touch buffer layer S-BF, the touch driving link line TLL, and the touch insulating layer S-ILD may be disposed to overlap the end of the pad cover portion PDCP disposed on the touch pad TPD. The touch insulating layer S-ILD overlapping the pad cover portion PDCP may have at least a portion removed to form a contact hole TCH.

Touch connection pad electrode TPE_CP may be disposed on the pad cover portion PDCP. The one end of the touch connection pad electrode TPE_CP may extend toward the display area DA and may be electrically connected to the touch driving link line TLL through a contact hole TCH passing through the touch insulating layer S-ILD. The other end of the touch connection pad electrode TPE_CP may extend toward the pad area PA and may be electrically connected to the touch pad electrode TPE exposed through an opening pattern TPE_OP of the pad cover portion PDCP.

In another embodiment of the disclosure, the touch driving link line TLL may be configured to be electrically connected to the touch pad electrode TPE through the touch connection pad electrode TPE_CP on the pad cover portion PDCP, thereby preventing damage or cracking defects of the inorganic layer disposed in the pad area PA during the ToE (Touch on Encapsulation) process following the array process forming the data lines DL, the scan lines SL, or the pixel circuits in the display area DA, and minimizing film lifting of the pad cover portion PDCP. Accordingly, by improving moisture permeability reliability in the pad area PA, corrosion defects of the touch driving link line TLL may be effectively prevented, thereby realizing the light emitting display apparatus with enhanced reliability in high-temperature and high-humidity environments.

The above-described feature, structure, and effect of the disclosure are included in at least one embodiment of the disclosure, but are not limited to only one embodiment. Furthermore, the feature, structure, and effect described in at least one embodiment of the disclosure may be implemented through combination or modification of other embodiments by those skilled in the art. Therefore, content associated with the combination and modification should be construed as being within the scope of the disclosure.

It will be apparent to those skilled in the art that various modifications and variations can be made in the disclosure without departing from the scope of the disclosures. Thus, it is intended that the present disclosure covers the modifications and variations of this disclosure provided they come within the scope of the appended claims and their equivalents.

## Claims

1. A light emitting display apparatus comprising:
a substrate (111) having a display area (DA) and a pad area (PA);
an encapsulation portion (ENC) extending from the display area (DA) toward the pad area (PA) on the substrate (111);
at least one inorganic insulating layer (S-BF, S-ILD) disposed on the encapsulation portion (ENC);
a pad electrode (DPE, TPE) disposed in the pad area (PA) on the substrate (111) and electrically connected to respective signal link lines (SLL1, SLL2, TLL); and
a pad cover portion (PDCP) configured to cover at least a portion of the pad electrode (DPE, TPE) in the pad area (PA),
wherein the at least one inorganic insulating layer (S-BF, S-ILD) includes an extension pattern portion (S-EP) configured to overlap an end of the pad cover portion (PDCP).

2. The light emitting display apparatus of claim 1, wherein the extension pattern portion (S-EP) extends from one side of the at least one inorganic insulating layer (S-BF, S-ILD) to overlap the respective signal link lines (SLL1, SLL2, TLL), and/or the extension pattern portion (S-EP) includes a plurality of finger patterns overlapping the respective signal link lines (SLL1, SLL2, TLL), preferably the extension pattern portion (S-EP) has a slit shape between the adjacent signal link lines (SLL1, SLL2, TLL).

3. The light emitting display apparatus of claim 1 or 2, wherein the pad electrode includes a plurality of pad electrodes (DPE, TPE) extend in a first direction on the substrate (111),
wherein the pad cover portion (PDCP) is configured to extend in the first direction to cover the plurality of pad electrodes (DPE, TPE), preferably the pad cover portion (PDCP) comprises an organic material.

4. The light emitting display apparatus according to any one of the preceding claims, further comprising:
a pixel circuit layer having a pixel circuit and disposed in the display area (DA) on the substrate (111);
a planarization layer (PLN) configured to cover the pixel circuit layer in the display area (DA); and
a light emitting device (ED) disposed on the planarization layer (PLN) in the display area (DA) and connected to the pixel circuit,
wherein the encapsulation portion (ENC) is disposed on the planarization layer (PNL) to cover the light emitting device (ED), preferably the pad cover portion (PDCP) comprises the same material as the planarization layer (PNL), and/or has a height that is equal to or lower than that of the planarization layer (PNL).

5. The light emitting display apparatus of any one of the preceding claims, wherein the signal link line (SLL1, SLL2, TLL) includes a display driving link line (SLL), at least one portion of which disposed in the same layer as a gate electrode (GE) of a thin film transistor (TFT) included in the pixel circuit and as a gate line,
preferably the display driving link line (SLL) is connected to the pad electrode (DPE), extends to the display area (DA), and is electrically connected to a data line (DL) disposed in the display area (DA).

6. The light emitting display apparatus of any one of the preceding claims, wherein the pixel circuit layer includes an interlayer insulating layer (ILD1, ILD2) disposed on the gate electrode (GE), and/or a interlayer insulating layer (ILD1, ILD2) is disposed to extend to the pad area (PA) on the substrate (111), preferably the pad electrode includes a display pad electrode (DPE) electrically connected to the display driving link line (SLL) through a contact hole (CH) passing through the interlayer insulating layer (ILD1, ILD2).

7. The light emitting display apparatus of any one of the preceding claims, wherein the pad cover portion (PDCH) covers at least a portion of a display pad electrode (DPE), preferably the pad cover portion (PDCH) includes an opening pattern (DPE_OP) exposing another portion of the display pad electrode (DPE).

8. The light emitting display apparatus of claim 7, further comprising a display connection pad electrode (DPE_CP) disposed on the pad cover portion (PDCP), one end of the display connection pad electrode (DPE_CP) is spaced apart from the extension pattern portion (S-EP) on the pad cover portion (PDCP),
wherein another end of the display connection pad electrode (DPE_CP) extends toward the pad area (PA), and is electrically connected to the display pad electrode (DPE) exposed through the opening pattern (DPE_OP) of the pad cover portion (PDCP).

9. The light emitting display apparatus of any one of the preceding claims, wherein the at least one inorganic insulating layer (S-BF, S-ILD) includes:
a touch buffer layer (S-BF) disposed on the encapsulation portion (ENC); and
a touch insulating layer (S-ILD) disposed on the touch buffer layer (S-BF),
wherein the touch buffer layer (S-BF) and the touch insulating layer (S-ILD) extend to overlap the display driving link line (SLL) and the end of the pad cover portion (PDCP).

10. The light emitting display apparatus of any one of the preceding claims 6-9, wherein the display driving link line (SLL) includes first and second display driving link lines (SLL1, SLL2) overlapping to form a single signal line, and
wherein the first display driving link line (SLL1) is formed of the same material in a same layer as the gate electrode (GE), and the second display driving link line (SLL2) is formed of the same material in a same layer as an intermediate metal layer (TM) disposed in the interlayer insulating layer (ILD1).

11. The light emitting display apparatus of any one of the preceding claims, further comprising a touch electrode (TE) array disposed on the encapsulation portion (ENC) in the display area (DA),
wherein the signal link line (SLL) includes a touch driving link line (TLL) electrically connected to the touch electrode array (TE).

12. The light emitting display apparatus of claim 11, wherein the at least one inorganic insulating layer (S-BF, S-ILD) includes:
a touch buffer layer (S-BF) disposed on the encapsulation portion (ENC); and
a touch insulating layer (S-ILD) disposed on the touch buffer layer (S-BF),
wherein the touch driving link line (TLL) are disposed between the touch buffer layer (S-BF) and the touch insulating layer (S-ILD), and
wherein the touch driving link line (TLL) is disposed to overlap the end of the pad cover portion (PDCP) between the touch buffer layer (S-BF) and the touch insulating layer (S-ILD).

13. The light emitting display apparatus of claim 11 or 12, wherein the extension pattern portion (S-EP) includes the touch insulating layer (S-ILD) disposed above the touch driving link line (TLL) and the touch buffer layer (S-BF) disposed below the touch driving link line (TLL) and/or the pad electrode includes a touch pad electrode (TPE) electrically connected to the touch driving link.

14. The light emitting display apparatus of claim 13, further comprising a touch connection pad electrode (TPE_CP) disposed on the pad cover portion (PDCP),
wherein one end of the touch connection pad electrode (TPE_CP) extends toward the display area (DA) and is electrically connected to the touch driving link line (TLL) through a contact hole (CH) passing through the touch insulating layer (S-ILD), and
wherein another end of the touch connection pad electrode (TPE_CP) extends toward the pad area (PA) and is electrically connected to the touch pad electrode (TPE) exposed through the opening pattern (TPE_OP) of the pad cover portion (PDCP).

15. The light emitting display apparatus of any one of the preceding claims, wherein the encapsulation portion (ENC) covers the entire display area (DA) and extends to a non-display area (NDA) except for the pad area (PA).
